# EUROPEAN PATENT SPECIFICATION

(11) **EP 3 010 152 B1**
(45) Date of publication and mention of the grant of the patent: **14.11.2018**
(21) Application number: 14810498.7
(22) Date of filing: 27.05.2014
(51) Int. Cl.: H03K 17/687, H03K 17/14, H03K 17/56, H03K 17/16, G05F 3/26

(54) **GATE-DRIVING CIRCUIT**
GATE-ANTRIEBSSCHALTUNG
CIRCUIT DE COMMANDE DE PORTE

(30) Priority: 14.06.2013 JP 2013125173
(43) Date of publication of application: 20.04.2016
(73) Proprietor: Fuji Electric Co., Ltd., Kawasaki-shi Kanagawa 210-9530 (JP)
(72) Inventor: AKAHANE, Masashi, Kawasaki-shi Kanagawa 210-9530 (JP)
(74) Representative: MERH-IP Matias Erny Reichl Hoffmann Patentanwälte PartG mbB
(86) International application number: PCT/JP2014/063921
(87) International publication number: WO 2014/199818

(56) References cited:
- EP-A1- 2 354 882
- JP-A- H06 216 735
- JP-A- 2003 338 744
- JP-A- 2005 123 666
- JP-A- 2008 103 895
- US-A1- 2005 207 228
- US-A1- 2007 030 055
- US-A1- 2008 094 111
- US-A1- 2013 147 525

## Description

### Technical Field

The present invention relates to a gate drive circuit wherein the output current of an output transistor which drives a switching element on/off can be kept constant regardless of a fluctuation in temperature or supply voltage.

### Background Art

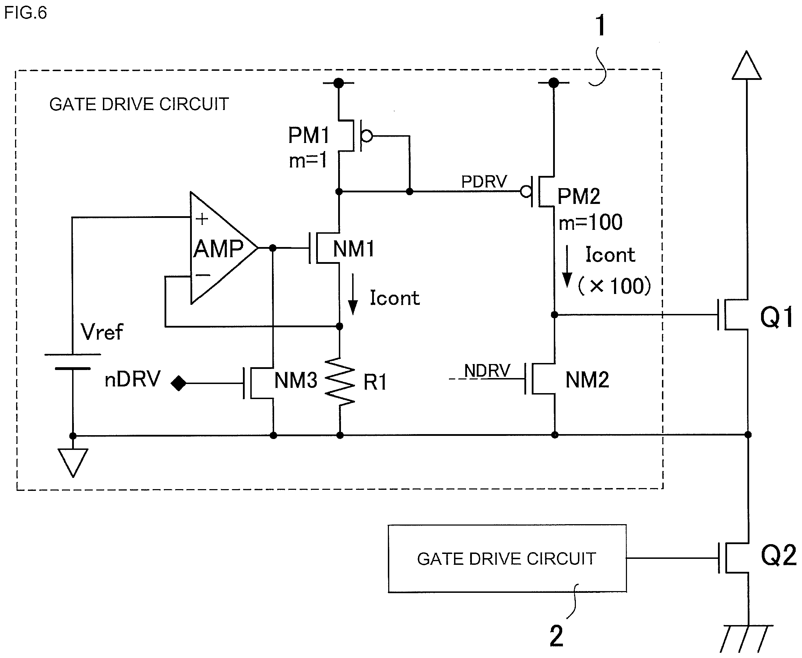

A gate drive circuit which drives on/off a switching element such as an IGBT or MOS-FET in a power converter is configured in such a way as in, for example, Fig. 6. In Fig. 6, Q1 and Q2 are switching elements, each formed of a MOS-FET forming a half bridge circuit, and 1 is a gate drive circuit which drives the high side switching element Q1 on/off. A gate drive circuit 2 which drives the low side switching element Q2 on/off is also configured in the same way as the gate drive circuit 1. Consequently, herein, a description will be given of the gate drive circuit 1 which drives the high side switching element Q1.

The gate drive circuit 1 includes an output transistor PM2, formed of a p-channel MOS-FET, which supplies a constant current to the gate of the switching element Q1 and drives the switching element Q1 on/off. Furthermore, the gate drive circuit 1 includes an output transistor NM2, formed of an n-channel MOS-FET connected in totem pole fashion to the output transistor PM2, which is controlled on/off in a complementary relationship with the output transistor PM2.

Also, the gate drive circuit 1 includes a transistor PM1, formed of a p-channel MOS-FET, which configures a current mirror circuit with the output transistor PM2. Furthermore, the gate drive circuit 1 includes a control transistor NM1, formed of an n-channel MOS-FET, a current Icont of which is controlled by the output of an error amplifier AMP with the transistor PM1 as a load. Incidentally, the error amplifier AMP assumes the role of making the current Icont constant in response to a differential voltage between a voltage, generated in a resistor R1 in response to the current Icont flowing through the control transistor NM1, and a reference voltage Vref.

Also, a transistor NM3, which is formed of an n-channel MOS-FET and is driven on/off in response to a gate control signal nDRV, controls on/off the drive of the control transistor NM1 by the output of the error amplifier AMP. By the control transistor NM1 operating to turn on, the current Icont flowing through the control transistor NM1 flows via the transistor PM1. As a result of this, a current proportional to the current Icont flows through the output transistor PM2 configuring the current mirror circuit with the transistor PM1. The current is supplied to the gate of the switching element Q1, and the switching element Q1 is driven on.

That is, the gate drive circuit 1 of the heretofore described configuration, in accordance with the constant current Icont generated by the error amplifier AMP and control transistor NM1, controls the on-current of the output transistor PM2 via the transistor PM1. Further, the gate drive circuit 1, under the current control, drives the switching element Q1 on with the constant current. Consequently, the time to charge the gate capacitance of the switching element Q1 is made constant even when there is a fluctuation in temperature or supply voltage. As a result of this, the turn-on time of the switching element Q1 is kept constant.

Also, Fig. 7 shows a gate drive circuit introduced in PTL 1. The gate drive circuit 3 is configured in such a way as to control on/off an output transistor 4, which is formed of a p-channel MOS-FET and drives the switching element Q1 on/off, using a pre-driver 7 of a CMOS configuration formed of a p-channel MOS-FET 5 and n-channel MOS-FET 6. Further, the source voltage which is the operating reference voltage of the n-channel MOS-FET 6 in the pre-driver 7 is defined by a constant voltage source 8, thereby driving the switching element Q1 with a constant voltage Vg1.

Further, PTL 2 discloses a drive circuit for an insulated gate device that includes a constant current source generating a constant current, and a switching circuit, wherein a gate of the insulated gate device is connected to a power supply potential side via the constant current source at the time of turn-on and to a ground potential side at the time of turn-off.

Next, PTL 3 discloses a semiconductor integrated circuit provided with a single-stage output transistor for supplying write current to a magnetic head, a current source for outputting reference current of the write current, a diode-connected NMOS transistor for converting the current to gate voltage and having a certain device size ratio to the output transistor, a regulator circuit for transmitting gate voltage of the NMOS transistor and reducing output impedance, and a CMOS circuit for setting power supply voltage to an output of the regulator circuit and controlling the gate voltage of the output transistor. Then, this circuit is applied as a write circuit in a magnetic storage device.

Further, PTL 4 discloses a constant current circuit that generates a constant output current corresponding to an input voltage, comprising a differential amplifying unit to which the input voltage and a feedback voltage to be compared therewith are applied, the differential amplifying unit outputting a differential voltage between the input voltage and the feedback voltage, a first transistor with a first control electrode to which the differential voltage is applied, a first diode element that is connected to a power-supply side electrode of the first transistor, one or a plurality of second transistors that generates the output current duplicated from a diode current by applying to a second control electrode a voltage drop in the first diode element developed as a result of the diode current flowing through the first diode element due to drive of the first transistor,; a feedback voltage conversion block that converts the duplicated current of the diode current flowing through the second transistor into the feedback voltage, which is fed back to the differential amplifying unit, and a constant current loading unit that is connected to a ground side electrode of the first transistor, the constant current loading unit making a voltage change in the ground side electrode follow a voltage change in the first control electrode, the constant current loading unit acting as a constant current load on the ground side of the first transistor.

Next, PTL 5 discloses a method and circuit for providing a switched current source output that has a precharge mode, in which a charge storage device is charged to a reference voltage, and the gate of an output transistor is discharged. In a discharge mode, the charge storage device is discharged to the gate of the output transistor to raise the gate voltage by an amount depending on the charge flow.

### Citation List

### Patent Literature

PTL 1: JP-A-2010-193431
PTL 2: US2008/094111 (A1)
PTL 3: US2005/207228 (A1)
PTL 4: US2007/030055 (A1)
PTL 5: EP 2 354 882 (A1)

### Summary of Invention

### Technical Problem

In the meantime, in the gate drive circuit 1 of the configuration shown in Fig. 6, a control signal which drives the output transistor PM2 on/off is generated using the error amplifier AMP. Therefore, there is the problem that a delay occurs in the control of the output transistor PM2 due to a response delay of the error amplifier AMP. Also, in the gate drive circuit 1, in order to change the gate resistance for the switching element Q1, it may happen that a plurality of the output transistors PM2 are provided in parallel. In this case, it is necessary to provide a control circuit section including the transistor PM1, NM1, or the like, for each output transistor PM2. Hence, this configuration includes the problem of leading to a large scale.

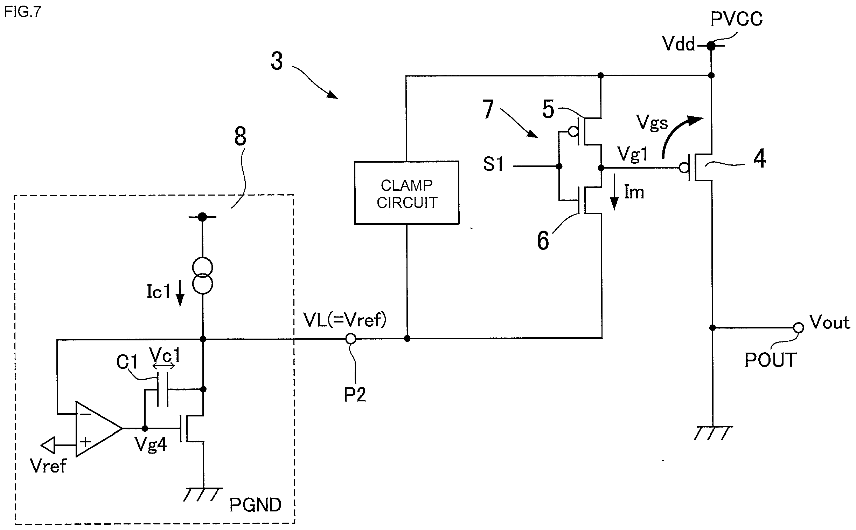

Also, in the gate drive circuit 3 of the configuration shown in Fig. 7, it is possible to make constant the voltage Vg1 which drives the output transistor 4 on. However, when there is a fluctuation in temperature or supply voltage, an on-current Im flowing through the n-channel MOS-FET 6 in the pre-driver 7 changes. Then, there is the disadvantage that the time to charge the gate capacitance of the output transistor 4 changes, as a result of which the turn-on time of the output transistor 4 varies.

The invention, having been contrived bearing in mind these kinds of circumstances, has its object to provide a gate drive circuit of a simple configuration wherein the output current of an output transistor which drives a switching element on/off is kept constant regardless of a fluctuation in temperature or supply voltage, and the turn-on time of the output transistor can thereby be stabilized.

### Solution to Problem

In order to achieve the heretofore described object, a gate drive circuit according to claim 1 is described.

It is preferable that the reference current source includes an error amplifier which obtains a voltage difference between a voltage generated in a reference resistor by the current flowing through the constant current transistor and a preset reference voltage, and that the reference current source is configured in such a way as to make constant the current flowing through the constant current transistor by feedback controlling the gate voltage of the constant current transistor in response to the output of the error amplifier. Incidentally, the reference resistor is formed of a resistor which can ignore temperature dependence.

Also, the output transistor and the constant current transistor are each formed of a MOS-FET. Further, the pre-driver, whose operating reference voltage is set via the buffer amplifier, assumes the role of making a current flowing through the output transistor, proportional to the current flowing through the constant current transistor, when the pre-driver inputs the gate control signal and drives the output transistor on.

It is preferable that when a plurality of the output transistors are provided connected in parallel, a plurality of the pre-drivers are provided so as to correspond to the respective output transistors. The plurality of pre-drivers assume the role of selectively setting a gate current, which drives the switching element on/off, by individually inputting the gate control signals and driving the respective output transistors on/off.

In addition to the heretofore described configurations, it is also required according to the invention to include a capacitor which selectively holds the gate voltage of the constant current transistor via a switch element, and applies the held gate voltage to the buffer amplifier. In the gate drive circuit configured in this way, the switch element assumes the role of causing the capacitor to hold the gate voltage of the constant current transistor when the output transistor operates to turn off upon receiving the gate control signal input into the pre-driver. Also, the reference current source is configured in such a way as to be driven on/off together with the switch element.

### Advantageous Effects of Invention

According to the gate drive circuit of the heretofore described configuration, the pre-driver can be driven on/off by the current proportional to the current defined by the reference current source. Moreover, the current defined by the reference current source can be kept constant regardless of a fluctuation in temperature or supply voltage. Consequently, it is possible to drive the output transistor with a constant current regardless of a fluctuation in temperature or supply voltage, and thus possible to keep the turn-on time of the output transistor always constant and stable.

As a result of this, according to the gate drive circuit according to the invention, it is possible to stably drive the switching element without causing the problem of a response time delay due to a fluctuation in temperature or supply voltage. Moreover, as the configuration of the gate drive circuit is simple, it does not happen that the configuration of the gate drive circuit is large-scaled even when using a plurality of output transistors in parallel. Therefore, the practical advantage of the gate drive circuit is immense as a drive circuit for various kinds of switching elements in an intelligent power module IPM or the like.

### Brief Description of Drawings

[Fig. 1] Fig. 1 is a main portion outline configuration diagram showing a basic configuration of a gate drive circuit.
[Fig. 2] Fig. 2 is a diagram showing a change in a source current, which is an output current of an output transistor, with respect to a change in operating temperature.
[Fig. 3] Fig. 3 is a diagram showing a configuration example of a gate drive circuit.
[Fig. 4] Fig. 4 is a diagram showing a configuration example of a gate drive circuit.
[Fig. 5] Fig. 5 is a diagram showing a configuration example of a gate drive circuit according to the invention.
[Fig. 6] Fig. 6 is a diagram showing an example of a heretofore known gate drive circuit.
[Fig. 7] Fig. 7 is a diagram showing another example of the heretofore known gate drive circuit.

Hereafter, a description will be given, referring to the drawings, of some gate drive circuits and a gate drive circuit according to the invention.

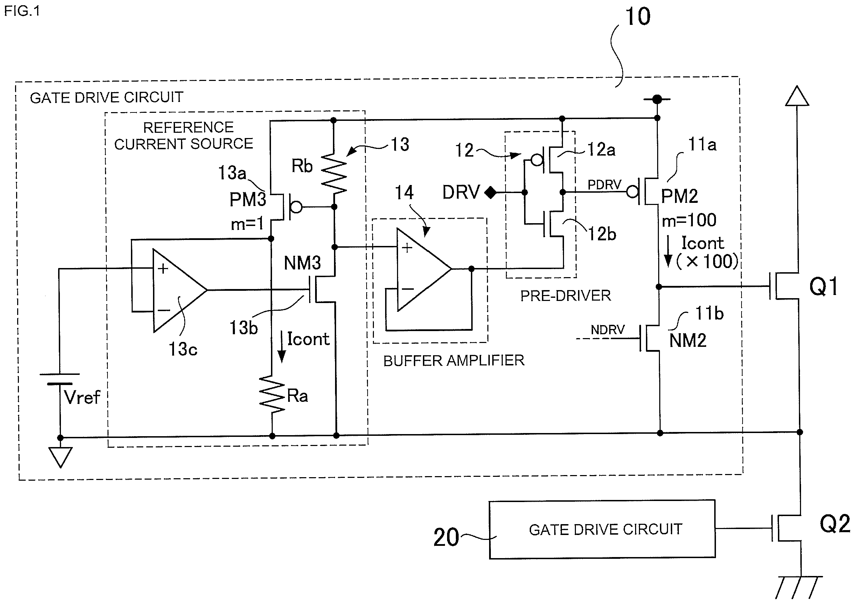

Fig. 1 is a main portion outline configuration diagram showing a basic configuration of a gate drive circuit 10, wherein 11a is a turn-on control output transistor formed of a p-channel MOS-FET; PM2, and 11b is a turn-off control output transistor formed of an n-channel MOS-FET; NM2. The output transistors 11a and 11b configure a totem pole circuit by connecting the drains of the output transistors 11a and 11b. Further, the output transistors 11a and 11b control the gate voltage of the previously described switching element Q1 using the drain voltages of the output transistors 11a and 11b, thereby driving the switching element Q1 on/off.

Also, the gate drive circuit 10 includes a pre-driver 12 of a CMOS configuration formed of a p-channel MOS-FET 12a and n-channel MOS-FET 12b. The pre-driver 12 assumes the role of driving the output transistor 11b on/off by being controlled on/off in response to a gate control signal DRV. The pre-driver 12 itself is the same as the previously described pre-driver 7 in the gate drive circuit 3 shown in Fig. 7.

Also, the gate drive circuit 10 includes a reference current source 13 configured mainly of a constant current transistor 13a formed of a p-channel MOS-FET; PM3, a voltage control transistor 13b formed of an n-channel MOS-FET; NM3, and an error amplifier 13c. The reference current source 13 includes a reference resistor Ra connected in series to the constant current transistor 13a and a load resistor Rb connected in series to the voltage control transistor 13b. The reference resistor Ra is formed of a resistor, having no change in resistance due to a temperature change, the so-called temperature dependence of which can be ignored.

Further, the error amplifier 13c drives the voltage control transistor 13b in response to a differential voltage between a voltage, generated in the reference resistor Ra in response to a current Icont flowing through the constant current transistor 13a, and a reference voltage Vref. The drain voltage of the voltage control transistor 13b is fed back as the gate voltage of the constant current transistor 13a, and the current Icont flowing through the constant current transistor 13a is thereby controlled so as to be made constant. Consequently, the gate voltage of the constant current transistor 13a is controlled so that the current Icont flowing through the constant current transistor 13a exhibits a constant value, regardless of a fluctuation in temperature or supply voltage, by the feedback control via the voltage control transistor 13b.

Now, the gate drive circuit 10 according to the invention is characterized in that the gate voltage of the constant current transistor 13a in the reference current source 13 is applied, as the operating reference voltage of the pre-driver 12, via a buffer amplifier 14 acting as an impedance conversion circuit. Specifically, the gate voltage of the constant current transistor 13a is applied, as the source voltage of the n-channel MOS-FET 12b of the pre-driver 12, via the buffer amplifier 14.

As the gate voltage of the constant current transistor 13a is then kept constant regardless of a fluctuation in temperature or supply voltage, as previously described, the source voltage which is the operating reference voltage of the n-channel MOS-FET 12b is also kept constant regardless of a fluctuation in temperature or supply voltage. That is, the source voltage of the n-channel MOS-FET 12b is controlled by the gate voltage of the constant current transistor 13a via the buffer amplifier 14. Hence, the pre-driver 12 is indirectly controlled in current mirror fashion by the reference current source 13 via the buffer amplifier 14. Consequently, a current proportional to the current Icont flows through the output transistor 11a, which operates to turn on/off upon receiving the output of the pre-driver 12 at the gate of the output transistor 11a, when the output transistor 11a operates to turn on.

At this time, the output transistor 11a is driven on with an always constant voltage by the pre-driver 12. Therefore, the time to charge the gate capacitance of the output transistor 11a is also always constant. Consequently, it is possible to stabilize the turn-on time of the output transistor 11a, and keep the turn-on time constant regardless of a fluctuation in temperature or supply voltage. Further, it is possible to always stably drive the switching element Q1 on with a constant current regardless of a fluctuation in temperature or supply voltage.

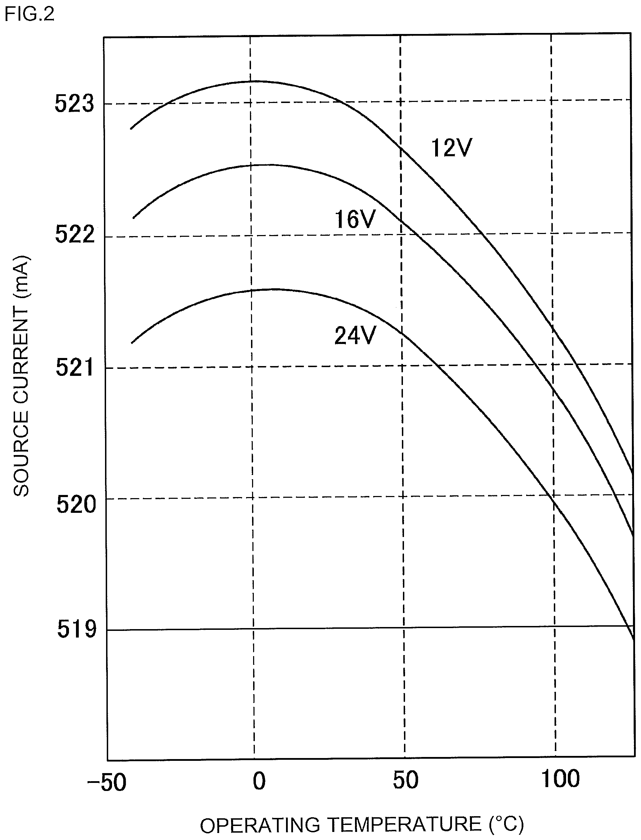

Fig. 2 shows temperature-change characteristics of a source current which is the output current of the output transistor 11a in the gate drive circuit 10 configured as heretofore described. As shown in Fig. 2, when the supply voltage is 12V in a temperature range of [-50°C to 125°C], the maximum current value of the supply voltage is [523.1mA], and the minimum current value is [520.1mA] . Also, when the supply voltage is 16V, the maximum current value of the supply voltage is [522.5mA], and the minimum current value is [519.7mA]. Further, when the supply voltage is 24V, the maximum current value of the supply voltage is [521.6mA], and the minimum current value is [518.8mA].

It can be confirmed from this that although the supply voltage changes in a range of 12V to 24V, the fluctuation range of the source current is kept to a maximum of [4.3mA], and that the fluctuation rate of the source current is less than 1%. That is, according to the gate drive circuit 10 configured in the heretofore described way, it can be confirmed that it is possible to make constant an output current supplied to drive the switching element Q1, and keep the output current always stable regardless of a fluctuation in temperature or supply voltage.

Next, a description will be given of other example circuits.

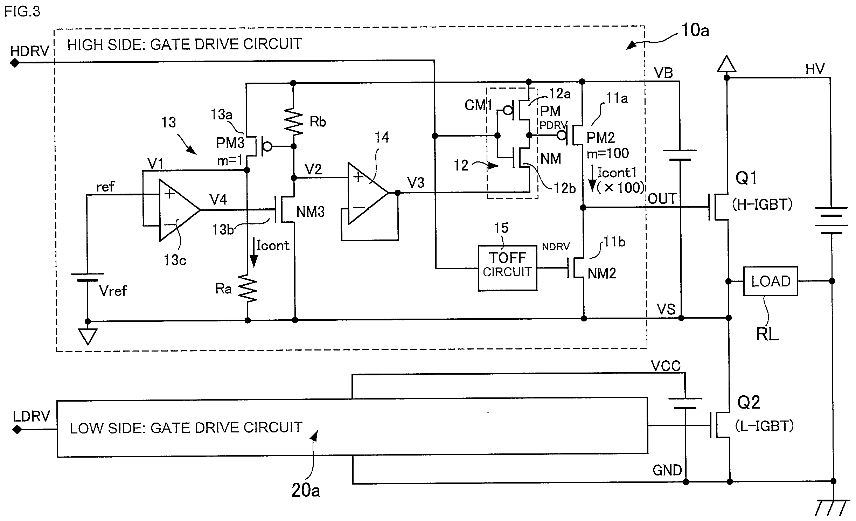

Fig. 3 shows a configuration example of a gate drive circuit 10a. The gate drive circuit 10a has a drive circuit section of the same configuration as in the gate drive circuit 10 shown in Fig. 1, as a drive circuit section for the output transistor 11a. Also, the gate drive circuit 10a includes a turn-off circuit (abbreviated to a TOFF circuit) 15 as a drive circuit section for the output transistor 11b which is connected in totem pole fashion, in series, to the output transistor 11a. The turn-off circuit 15 assumes the role of inputting the gate control signal DRV and driving the output transistor 11b on/off in a complementary relationship with the output transistor 11a.

Consequently, when the gate control signal DRV is [H] level, the output transistor 11a operates to turn on by the gate potential being set to the operating reference voltage, and as opposed to this, the output transistor 11b operates to turn off. Further, a current Icont1 is supplied to the gate of the switching element Q1 via the output transistor 11a, and the switching element Q1 turns on. Also, when the gate control signal DRV is [L] level, the output transistor 11a operates to turn off, while the output transistor 11b operates to turn on, and the switching element Q1 turns off.

Incidentally, the gate drive circuit 10a is used in driving on/off the high side switching element Q1 of a half bridge circuit configured by connecting two switching elements Q1 and Q2, each formed of an IGBT, in series. Also, the low side switching element Q2 of the half bridge circuit is driven on/off by a gate drive circuit 20a provided in parallel with the gate drive circuit 10a. The gate drive circuit 20a is configured in the same way as the gate drive circuit 10a, and a description thereof will be omitted.

The half bridge circuit assumes the role of switching a direct current high voltage HV and supplying alternating current power to a load RL connected to an output terminal which is the midpoint of the half bridge circuit. Herein, the high side gate drive circuit 10a is configured in such a way as to operate upon receiving a predetermined supply voltage VB with a midpoint potential VS of the half bridge circuit as a reference potential. Also, the low side gate drive circuit 20a is configured in such a way as to operate upon receiving a predetermined supply voltage VCC with a ground potential GND as a reference potential. This configuration is the same as that of a heretofore known common power converter configured including a half bridge circuit. Further, the gate drive circuits 10a and 20a operate by respectively inputting gate control signals HDRV and LDRV whose timing is controlled so that the switching elements Q1 and Q2 do not come into on-state at the same time.

According to the gate drive circuits 10a and 20a configured in this way, the switching elements Q1 and Q2 in the half bridge circuit are driven on/off respectively in response to the gate control signal HDRV and LDRV. At this time, the respective output currents of the gate drive circuits 10a and 10b which respectively drive the switching element Q1 and Q2 are made constant, as previously described. That is, as the source voltage which is the operating reference voltage of the n-channel MOS-FET 12b in the pre-driver 12 is defined by the gate voltage of the constant current transistor 13a, the source voltage is kept always constant regardless of a fluctuation in temperature or in the supply voltages VB and VCC.

Consequently, the pre-driver 12, which acts as a switch for the gate control signal DRV (HDRV, LDRV), drives the output transistor 11a on/off by operating to turn on/off with the source voltage of the n-channel MOS-FET 12b as a reference potential. As a result of this, the output transistor 11a is driven on upon receiving an always constant gate voltage. Consequently, the time to charge the gate capacitance of the output transistor 11a is also always constant, and it does not happen that the turn-on time of the output transistor 11a varies. Moreover, the source current of the output transistor 11a, which is the output current when the output transistor 11a is in on-operation, is also kept always constant.

Incidentally, it is supposed that channel lengths L of the constant current transistor 13a and output transistor 11a are equal, and that channel widths W of the transistors 13a and 11a are [1 : m] . In this case, a current m times (for example, 100 times) as large as the current Icont, which is made constant and flows through the constant current transistor 13a, flows through the output transistor 11a. Consequently, even though the constant current Icont defined in the reference current source 13 is, for example, 1mA, it is possible to obtain an output current of [m × Icont], for example, an output current of 100mA from the output transistor 11a. Therefore, it is possible to sufficiently afford to turn on the switching element Q1.

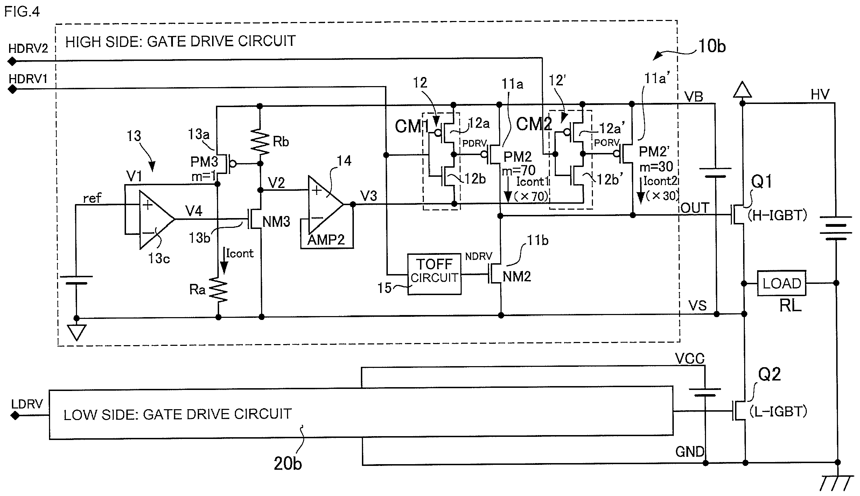

Fig. 4 shows a configuration example of a gate drive circuit 10b. In the second embodiment too, a low side gate drive circuit 20b is configured in the same way as the high side gate drive circuit 10b.

Herein, the gate drive circuit 10b is configured by providing two output transistors 11a and 11a', formed of p-channel MOS-FETs; PM2 and PM2' respectively, in parallel so that it is possible to change and set the output current of the output transistor 11a by changing the gate resistance for the output transistor 11a. Herein, an example wherein the two output transistors 11a and 11a' are provided in parallel is shown, but it is naturally also possible to provide three or more output transistors 11a in parallel.

In this case, two pre-drivers 12 and 12' are provided so as to correspond to the respective two output transistors 11a and 11a'. Also, the source voltages of n-channel MOS-FETs 12b and 12b' in the respective pre-drivers 12 and 12' are each defined by the gate voltage of the constant current transistor 13a via the buffer amplifier 14. Further, a configuration is adopted such that the pre-driver 12 is operated on/off by a main gate control signal HDRV1, while the pre-driver 12' is operated on/off by an auxiliary gate control signal HDRV2.

According to the gate drive circuit 10b configured in this way, the pre-drivers 12 and 12' only have to be provided so as to correspond to the respective two output transistors 11a and 11a' provided in parallel, and it is possible to produce the same advantageous effects as in the previously described first embodiment. Moreover, it is possible to simply realize the pre-drivers 12 and 12' themselves as a circuit of a CMOS configuration formed of p-channel MOS-FETs 12a and 12a' and n-channel MOS-FETs 12b and 12b'. Consequently, it is possible to produce an advantageous effect such that the configuration of the gate drive circuit 10b is not of a large scale, as in the previously described case of the heretofore known gate drive circuit shown in Fig. 6.

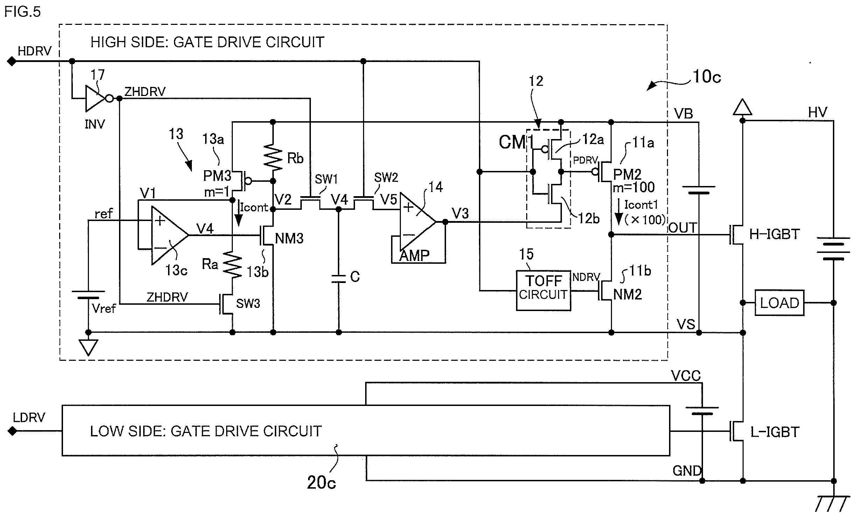

In the meantime, by configuring a gate drive circuit in the following way, it is also possible to achieve power saving in the gate drive circuit. Fig. 5 shows a configuration example of a gate drive circuit 10c according to the invention which achieves power saving. In the third embodiment too, a low side gate drive circuit 20c is configured in the same way as the high side gate drive circuit 10c.

The gate drive circuit 10c is characterized in that a capacitor C is provided between the reference current source 13 and the buffer amplifier 14, via switch elements SW1 and SW2, and that a switch element SW3 is provided connected to the reference resistor Ra of the reference current source 13. The switch elements SW1, SW2, and SW3 are each formed of, for example, an n-channel MOS-FET. Further, the gate drive circuit 10c is characterized by being configured in such a way that the switch element SW2 is driven on/off by the gate control signal HDRV, and that the switch elements SW1 and SW3 are driven on/off by a signal ZHDRV wherein the gate control signal HDRV is logically inverted via a NOT circuit 17.

Specifically, the capacitor C, being connected to the gate of the constant current transistor 13a via the first switch element SW1, is provided so as to be charged with the gate voltage of the constant current transistor 13a via the first switch element SW1 and hold the gate voltage. Further, a configuration is adopted such that the voltage with which the capacitor C is charged and which is held by the capacitor C is input into the buffer amplifier 14 via the second switch element SW2. Also, the third switch element SW3 assumes the role of causing the current Icont to flow through the constant current transistor 13a by operating to turn on at the same time as the first switch element SW1.

Thus, in the gate drive circuits 10c and 20c configured in this way, the reference current source 13 operates only when the gate control signal HDRV is [L] level. Further, at this time, the gate voltage of the constant current transistor 13a is held by the capacitor C, via the switch element SW1, in response to the current Icont flowing through the constant current transistor 13a. Further, when the gate control signal HDRV is inverted to [H] level, the operation of the reference current source 13 stops, and the voltage held by the capacitor C is given to the buffer amplifier 14 via the switch element SW2.

As a result of this, when the gate control signal HDRV changes to [H] level and the n-channel MOS-FET 12b of the pre-driver 12 operates to turn on, the source potential which is the operating reference voltage of the n-channel MOS-FET 12b is defined by the voltage held by the capacitor C and thus the gate voltage of the constant current transistor 13a. Consequently, in the gate drive circuits 10c and 20c of the heretofore described configuration too, it is possible to produce the same advantageous effects as those of each previous embodiment. Moreover, according to the gate drive circuits 10c and 20c, as the operation of generation of the constant current Icont by the reference current source 13 stops in response to the gate control signal HDRV, it is possible to reduce the power consumption of the reference current source 13 to substantially half compared with in the reference current sources 13 of the previously described gate drive circuits 10a, 10b, 20a, and 20b. Therefore, the gate drive circuits 10c and 20c have the advantage that the power-saving effect thereof is great compared with in the previously described embodiments .

The invention is not limited to each heretofore described embodiment. For example, in a kind of case wherein the input impedance of the buffer amplifier 14 is high, and self-discharge of the capacitor C can be ignored, the voltage held by the capacitor C can be held over a period in which the gate control signal HDRV is inverted to [H] level. Consequently, in this kind of case, it is possible to omit the switch element SW2.

Also, in each previously described gate drive circuit 10 and 20, it goes without describing that the invention can be applied also to the case of inserting a resistor between the output transistor 11a and the gate of the switching element Q1 and adjusting the turn-on time of the switching element Q1 with the resistor. Furthermore, it is only necessary that the size of the constant current Icont generated by the reference current source 13 and the ratio of the currents flowing through the constant current transistor 13a and output transistor 11a are also set in response to the specifications of the switching element Q1 which the gate drive circuit 10 is to drive. Also, it goes without saying that the invention can be similarly applied also to the case of using a high voltage MOS-FET as the switching element Q1.

### Reference Signs List

10, 10a, 10b, 10c Gate drive circuit (high side)
11a Output transistor (p-channel MOS-FET; PM2)
11b Output transistor (n-channel MOS-FET; NM2)
12, 12' Pre-driver
12a, 12a' p-channel MOS-FET
12b, 12b' n-channel MOS-FET
13 Reference current source
13a Constant current transistor (p-channel MOS-FET; PM3)
13b Voltage control transistor (n-channel MOS-FET; NM3)
13c Error amplifier
14 Buffer amplifier
15 Turn-off circuit
20, 20a, 20b, 20c Gate drive circuit (low side)
Q1, Q2 Switching element
Ra Reference resistor
Rb Load resistor
SW1, SW2, SW3 Switch element (n-channel MOS-FET)
C Capacitor

## Claims

1. A gate drive circuit (10c), comprising:
an output transistor (11a) which supplies a constant current to the gate of a switching element (Q1) and drives the switching element (Q1) on;
a pre-driver (12) of a CMOS configuration, formed of a p-channel MOS-FET (12a) and n-channel MOS-FET (12b), to which a gate control signal (HDRV) is inputted and which drives the output transistor (11a) on/off;
a reference current source (13) which controls the gate voltage of a constant current transistor (13a) and makes constant a current (Icont) flowing through the constant current transistor (13a);
a buffer amplifier (14) which applies the gate voltage of the constant current transistor (13a) as the operating reference voltage of the pre-driver (12);
a capacitor (C) which selectively holds the gate voltage of the constant current transistor (13a) via a switch element (SW1, SW2), and applies the held gate voltage to the buffer amplifier (14), wherein
the reference current source (13) is driven on/off together with a further switch element (SW3).

2. The gate drive circuit (10c) according to claim 1, wherein
the reference current source (13) includes an error amplifier (13c) which obtains a voltage difference between a voltage generated in a reference resistor (Ra) by the current flowing through the constant current transistor (13a) and a preset reference voltage, and the reference current source (13) makes constant the current flowing through the constant current transistor (13a) by feedback controlling the gate voltage of the constant current transistor (13a) in response to the output of the error amplifier (13c).

3. The gate drive circuit (10c) according to claim 2, wherein
the reference resistor (Ra) is formed of a resistor which can ignore temperature dependence.

4. The gate drive circuit (10c) according to claim 1, wherein
the output transistor (11a) and the constant current transistor (13a) are each formed of a MOS-FET.

5. The gate drive circuit (10c) according to claim 1, wherein
the pre-driver (12), whose operating reference voltage is set via the buffer amplifier (14), causes a current proportional to the current flowing through the constant current transistor (13a) to flow when the gate control signal is inputted to the pre-driver (12) and the pre-driver (12) drives the output transistor (11a) on.

6. The gate drive circuit (10c) according to claim 1, wherein
when a plurality of the output transistors (11a, 11a') are provided connected in parallel, a plurality of the pre-drivers (12, 12') are provided so as to correspond to the respective output transistors (11a, 11a').

7. The gate drive circuit (10c) according to claim 6, wherein
the gate control signals are inputted to the plurality of pre-drivers (12, 12') individually and the plurality of pre-drivers (12, 12') drive the respective output transistors (11a, 11a') on/off.

8. The gate drive circuit (10c) according to one of the preceding claims, wherein
the switch element (SW1, SW2) causes the capacitor (C) to hold the gate voltage of the constant current transistor (13a) when the output transistor (11a) is off-state upon receiving the gate control signal input into the pre-driver (12).

## Patentansprüche

1. Gate-Treiberschaltung (10c), umfassend:
einen Ausgangstransistor (11a), der einen konstanten Strom zu dem Gate eines Schaltelements (Q1) zuführt und das Schaltelement (Q1) einschaltet;
einen Vortreiber (12) einer CMOS-Konfiguration, die aus einem p-Kanal-MOSFET (12a) und einem n-Kanal MOSFET (12b) gebildet ist, in die ein Gate-Steuersignal (HDRV) eingegeben wird und die den Ausgangstransistor (11a) ein-/ausschaltet;
eine Referenzstromquelle (13), welche die Gate-Spannung eines Transistors (13a) für konstanten Strom steuert und einen Strom (Icont), der durch den Transistor (13a) für konstanten Strom fließt, konstant macht;
einen Pufferverstärker (14), der die Gate-Spannung des Transistors (13a) für konstanten Strom als Betriebsreferenzspannung des Vortreibers (12) anlegt;
einen Kondensator (C), der selektiv die Gate-Spannung des Transistors (13a) für konstanten Strom anhand eines Schaltelements (SW1, SW2) selektiv hält und die gehaltene Gate-Spannung an den Pufferverstärker (14) anlegt, wobei
die Referenzstromquelle (13) zusammen mit einem weiteren Schaltelement (SW3) ein-/ausgeschaltet wird.

2. Gate-Treiberschaltung (10c) nach Anspruch 1, wobei die Referenzstromquelle (13) einen Fehlerverstärker (13c) umfasst, der eine Spannungsdifferenz zwischen einer Spannung, die in einem Referenzwiderstand (Ra) durch den Strom erzeugt wird, der durch den Transistor (13a) für konstanten Strom fließt, und einer voreingestellten Referenzspannung erzielt, und die Referenzstromquelle (13) den Strom, der durch den Transistor (13a) für konstanten Strom fließt, durch Regeln der Gate-Spannung des Transistors (13a) für konstanten Strom als Reaktion auf die Ausgabe des Fehlerverstärkers (13c) konstant macht.

3. Gate-Treiberschaltung (10c) nach Anspruch 2, wobei der Referenzwiderstand (Ra) aus einem Widerstand besteht, der eine Temperaturabhängigkeit ignorieren kann.

4. Gate-Treiberschaltung (10c) nach Anspruch 1, wobei der Ausgangstransistor (11a) und der Transistor (13a) für konstanten Strom jeweils aus einem MOSFET bestehen.

5. Gate-Treiberschaltung (10c) nach Anspruch 1, wobei der Vortreiber (12), dessen Betriebsreferenzspannung anhand des Pufferverstärkers (14) eingestellt wird, bewirkt, dass ein Strom fließt, der zu dem Strom proportional ist, der durch den Transistor (13a) für konstanten Strom fließt, wenn das Gate-Steuersignal in den Vortreiber (12) eingegeben wird und der Vortreiber (12) den Ausgangstransistor (11a) einschaltet.

6. Gate-Treiberschaltung (10c) nach Anspruch 1, wobei, wenn eine Vielzahl der Ausgangstransistoren (11a, 11a') parallel geschaltet bereitgestellt wird, eine Vielzahl der Vortreiber (12, 12') bereitgestellt wird, um den jeweiligen Ausgangstransistoren (11a, 11a') zu entsprechen.

7. Gate-Treiberschaltung (10c) nach Anspruch 6, wobei die Gate-Steuersignale in die Vielzahl von Vortreibern (12, 12') einzeln eingegeben werden und die Vielzahl von Vortreibern (12, 12') die jeweiligen Ausgangstransistoren (11a, 11a') ein-/ausschalten.

8. Gate-Treiberschaltung (10c) nach einem der vorhergehenden Ansprüche, wobei das Schaltelement (SW1, SW2) bewirkt, dass der Kondensator (C) die Gate-Spannung des Transistors (13a) für konstanten Strom hält, wenn sich der Ausgangstransistor (11a) in einem ausgeschalteten Zustand befindet, wenn er das Gate-Steuersignal empfängt, das in den Vortreiber (12) eingegeben wird.

## Revendications

1. Circuit de pilotage de grille (10c), comprenant :
un transistor de sortie (11a) qui fournit un courant constant à la grille d'un élément de commutation (Q1) et pilote l'élément de commutation (Q1) dans l'état fermé ;
un pré-dispositif de pilotage (12) d'une configuration CMOS, formé d'un MOS-FET à canal p (12a) et d'un MOS-FET à canal n (12b), sur lequel un signal de commande de grille (HDRV) est entré et qui pilote le transistor de sortie (11a) dans l'état fermé/ouvert ;
une source de courant de référence (13) qui commande la tension de grille d'un transistor à courant constant (13a) et rend constant un courant (Icont) circulant à travers le transistor à courant constant (13a) ;
un amplificateur tampon (14) qui applique la tension de grille du transistor à courant constant (13a) en tant que tension de référence de fonctionnement du pré-dispositif de pilotage (12) ;
un condensateur (C) qui maintient sélectivement la tension de grille du transistor à courant constant (13a) par l'intermédiaire d'un élément de commutateur (SW1, SW2), et applique la tension de grille maintenue à l'amplificateur tampon (14),
la source de courant de référence (13) étant allumée/éteinte conjointement avec un autre élément de commutateur (SW3).

2. Circuit de pilotage de grille (10c) selon la revendication 1, dans lequel la source de courant de référence (13) comprend un amplificateur d'erreur (13c) qui obtient une différence de tension entre une tension générée dans une résistance de référence (Ra) par le courant circulant à travers le transistor à courant constant (13a) et une tension de référence prédéfinie, et la source de courant de référence (13) rend constant le courant circulant à travers le transistor à courant constant (13a) par asservissement de la tension de grille du transistor à courant constant (13a) en réponse à la sortie de l'amplificateur d'erreur (13c).

3. Circuit de pilotage de grille (10c) selon la revendication 2, dans lequel la résistance de référence (Ra) est formée d'une résistance qui peut ignorer une dépendance à la température.

4. Circuit de pilotage de grille (10c) selon la revendication 1, dans lequel le transistor de sortie (11a) et le transistor à courant constant (13a) sont chacun formés d'un MOS-FET.

5. Circuit de pilotage de grille (10c) selon la revendication 1, dans lequel le pré-dispositif de pilotage (12), dont la tension de référence de fonctionnement est définie par l'intermédiaire de l'amplificateur tampon (14), amène un courant proportionnel au courant circulant à travers le transistor à courant constant (13a) à circuler lorsque le signal de commande de grille est entré sur le pré-dispositif de pilotage (12) et le pré-dispositif de pilotage (12) pilote le transistor de sortie (11a) dans l'état fermé,

6. Circuit de pilotage de grille (10c) selon la revendication 1, dans lequel, lorsqu'une pluralité des transistors de sortie (11a, 11a') sont disposés reliés en parallèle, une pluralité des pré-dispositifs de pilotage (12, 12') sont disposés de façon à correspondre aux transistors de sortie respectifs (11a, 11a').

7. Circuit de pilotage de grille (10c) selon la revendication 6, dans lequel les signaux de commande de grille sont entrés sur la pluralité de pré-dispositifs de pilotage (12, 12') individuellement et la pluralité de pré-dispositifs de pilotage (12, 12') pilotent les transistors de sortie respectifs (11a, 11a') dans l'état fermé/ouvert.

8. Circuit de pilotage de grille (10c) selon l'une des revendications précédentes, dans lequel l'élément de commutateur (SW1, SW2) amène le condensateur (C) à maintenir la tension de grille du transistor à courant constant (13a) lorsque le transistor de sortie (11a) est dans l'état ouvert lors de la réception du signal de commande de grille entré sur le pré-dispositif de pilotage (12) .
